(19) Europäisches Patentamt

European Patent Office

Office européen des brevets

(11) EP 0 660 587 B1

(12) **EUROPEAN PATENT SPECIFICATION**

(45) Date of publication and mention
of the grant of the patent:
**12.05.1999 Bulletin 1999/19**

(51) Int Cl.6: **H04N 1/41**

(21) Application number: **94111246.8**

(22) Date of filing: **19.07.1994**

(54) **Reversible video compression method**

Reversibles Videokompressionsverfahren

Procédé réversible de compression vidéo

(84) Designated Contracting States:
**DE FR GB IT**

(30) Priority: **20.12.1993 US 171315**

(43) Date of publication of application:
**28.06.1995 Bulletin 1995/26**

(73) Proprietor: **Hewlett-Packard Company
Palo Alto, California 94304 (US)**

(72) Inventors:
• **Morrison, Robert D.
Star, Idaho 83669 (US)**
• **Larson, Brad R.
Boise, Idaho 83704 (US)**

(74) Representative: **Schoppe, Fritz, Dipl.-Ing.
Schoppe & Zimmermann
Patentanwälte
Postfach 71 08 67
81458 München (DE)**

(56) References cited:
EP-A- 0 540 350      US-A- 4 568 983
US-A- 4 811 113      US-A- 5 148 292
US-A- 5 151 797

• IBM TECHNICAL DISCLOSURE BULLETIN, vol.
23, no. 11, April 1981, pages 5120-5124,
XP002013783 R.B. ARPS ET AL.: "LIFO
COMPRESSION CODING METHOD FOR
CONDITIONAL SOURCES"
• CCITT YELLOW BOOK FASCICLE VII.2-REC. T.4,
vol. VII, November 1980, GENEVA, pages
222-235, XP002013784 "TELEGRAPH AND
TELEMATIC SERVICES TERMINAL EQUIPMENT
- RECOMMENDATIONS OF THE S AND T
SERIES"

## Description

Technical Field

The present invention relates to data compression and decompression methods, more particularly, to a data compression and decompression methods that allows for decompression in the reverse direction.

Background of the Invention

Data compression systems are known in the prior art that encode a stream of digital data signals into compressed digital code signals and decode the compressed digital code signals back into the original data. Data compression refers to any process that attempts to convert data in a given format into an alternative format requiring less space than the original. The objective of data compression systems is to effect a savings in the amount of storage required to hold or the amount of time required to transmit a given body of digital information.

To be of practical utility, a general purpose digital data compression system should satisfy certain criteria. The system should have reciprocity. In order for a data compression system to possess the property of reciprocity it must be possible to re-expand or decode the compressed data back into its original form without any alteration or loss of information. The decoded and original data must be identical and indistinguishable with respect to each other. The property of reciprocity is synonymous to that of strict noiselessness used in information theory. Some applications do not require strict adherence to the property of reciprocity. One such application in particular is when dealing with graphical data. Because the human eye is not that sensitive to noise, some alteration or loss of information during the compression de-compression process is acceptable.

The system should provide sufficient performance with respect to the data rates provided by and accepted by the devices with which the data compression and de-compression systems are communicating. The rate at which data can be compressed is determined by the input data processing rate into the compression system, typically in millions of bytes per second (megabytes/sec). Sufficient performance is necessary to maintain the data rates achieved in present day disk, tape and communication systems which rates typically exceed one megabyte/sec. Thus, the data compression and de-compression system must have enough data throughput so as to not adversely affect the overall system. The performance of data compression and de-compression systems is typically limited by the computations necessary to compress and de-compress and the speed of the system components such as, random access memory (RAM), and the like, utilized to store statistical data and guide the compression and de-compression process. Performance for a compression device is characterized by the number of processor cycles required per input character under the compressor. The fewer the number of cycles, the higher the performance.

Another important criteria in the design of data compression and de-compression systems is compression effectiveness, which is characterized by the compression ratio. The compression ratio is the ratio of data size in uncompressed form divided by the size in compressed form. In order for data to be compressible, the data must contain redundancy. Compression effectiveness is determined by how effectively the compression procedure uses the redundancy in the input data. In typical computer stored data, redundancy occurs both in the nonuniform usage of individual symbology, for example, digits, bytes, or characters, and in frequent recurrence of symbol sequences, such as common words, blank record fields and the like.

General purpose data compression procedures are also known in the prior art, three relevant procedures being the Huffman method, the Tunstall method and the Lempel-Ziv method. The Huffman method is widely known and used, reference thereto in article of D.A. Huffman entitled "A Method For Construction Of Minimum Redundancy Codes", Proceedings IRE, 40, 10, pages 1098-1100 (Sept. 1952). Reference to the Tunstall algorithm may be found in Doctoral thesis of B. P. Tunstall entitled "Synthesis of Noiseless Compression Codes", Georgia Institute of Technology (Sept. 1967). Reference may be made to the Lempel-Ziv procedure in a paper authored by J. Ziv and A. Lempel entitled "A Universal Algorithm For Sequential Data Compression", IEEE Transactions on Information Theory, IT-23, 3, pages 337-343 (May, 1977).

One of the first general purpose data compression procedures developed is the Huffman method. Briefly described, the Huffman procedure maps full length segments of symbols into variable length words. The Huffman data compression procedure suffers from two limitations. Firstly, the Huffman procedure operates under the constraint that the input data to be compressed be parsed into fixed length segments of symbols. Although the Huffman procedure provides the best compression ratio that can be obtained under these constraints, when the constraint is relaxed it is possible to obtain significantly better compression ratios by utilizing other procedures. Secondly, Huffman coding requires full knowledge of the statistical characteristic of the source data. The Huffman procedure operates under the assumption that the probability with which each fixed length input segment occurs is known. This requirement of the Huffman procedure can in practice, be satisfied by the use of an adaptive version of the procedure which accumulates the necessary statistics during processing of the data. This, however, is cumbersome, and requires considerable working memory space and performs sub-optimally during adaptation.

The Tunstall algorithm, which maps variable length segments of symbols into fixed length binary words, is complimentary to the Huffman procedure with the fixed length constraints now applied to the output segments instead of the input segments. Like the Huffman procedure, the Tunstall procedure requires a foreknowledge of the source data probabilities. Again this foreknowledge requirement can be satisfied to some degree by utilizing an adaptive version which accumulates the statistics during processing of the data.

The Lempel-Ziv procedure maps variable length segments of the symbols into variable length binary words. It is asymptotically optimal when there are no constraints on the input or output segments. In this procedure the input data string is parsed into adaptively grown segments, each segment consisting of an exact copy of an earlier portion of the input string suffixed by one new symbol from the input data. The copy which is to be made is the longest possible and is not constrained to coincide with any earlier parsed segment. The code word which replaces the segment in the output contains information consisting of a pointer to where there earlier copied portion begins, the length of the copy, and the new symbol.

While the aforementioned data compression procedures are good general purpose procedures, some specific types of redundancy may be compressed using other procedures. One such procedure commonly known as run length encoding (RLE), is well suited for graphical image data. With RLE, sequences of identical characters can be encoded as a count field plus an identifier of the repeated character. Typically, two characters are needed to mark each character run, so this encoding would not be used for runs of two or fewer characters. However, when dealing with a graphical image represented in digital data form, there can be large runs of the same character in any given line, making RLE an effective compression procedure for such information.

Most applications require that the data be de-compressed in the same direction that was originally compressed. Certain very specific applications may require that the compression of the data occur in the reverse directions. For example, one such application is a printer that prints on both sides of the paper (duplex printing.) Printers which provide duplex printing require that the second page printed be printed from top to bottom and right to left. One such duplex printer is the LaserJet printer produced by the assignee of the present invention.

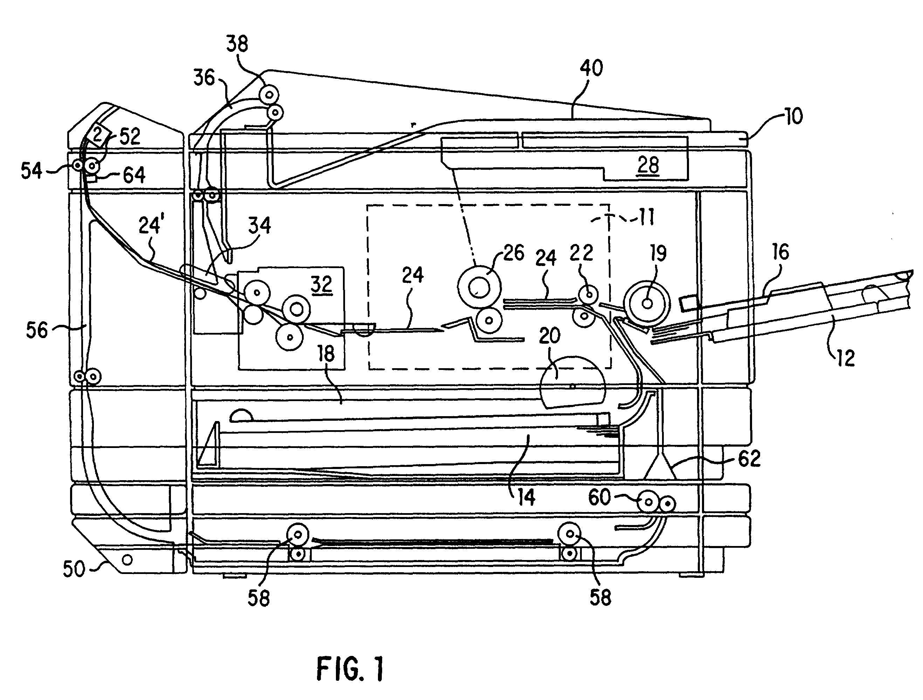

This need of reverse printing can best be understood with the aid of Figures 1 through 4 where a duplexing mechanism is shown. Duplexing mechanism 50 includes a reversing roller 52 and a slave roller 54 that are, respectively positioned on each side of a reversing path 56. An imprinting path extension 24' communicates with imprinting path 24 within the laser printer and is opened when duplex operation is desired. When in that position, select lever 34 closes off output pathway 36 thereby preventing a media sheet from exiting the printer during the duplex printing portion of the cycle.

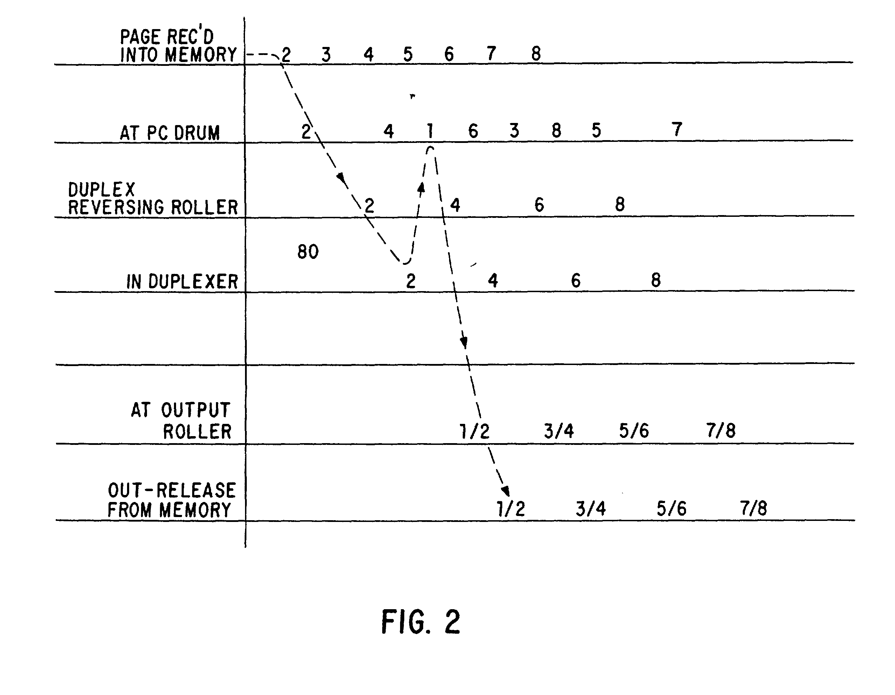

In Fig. 2, a timing diagram is illustrated for the duplexing system. For reasons understood to those skilled in the art of printers, even numbered pages are printed first to preserve proper paper order in the output tray. The horizontal axis of the chart of Fig. 2 indicated increments of time and each line of the chart indicates a specific station in the laser printer, and the numbers above each line indicate when the page bearing that number arise at that station. For instance, the first line of chart Fig. 2 indicates that the pages are received serially from a connected computer not shown. Note, that no printing action is commenced at PC drum 26 until both pages 1 and 2 are stored in memory, at which time, page 2 is printed first. As is shown by dashed line 80, page 2 then proceeds through reversing roller 52 and passes into the lower portion of the duplexer mechanism 50. The sheet bearing page 2 is then transported past PC drum 26 to enable page 1 to be printed on its front side. The duplexer printed media sheet bearing page 1 and 2 is then passed to output roller 38 where it exits onto output tray 40 and is released from memory.

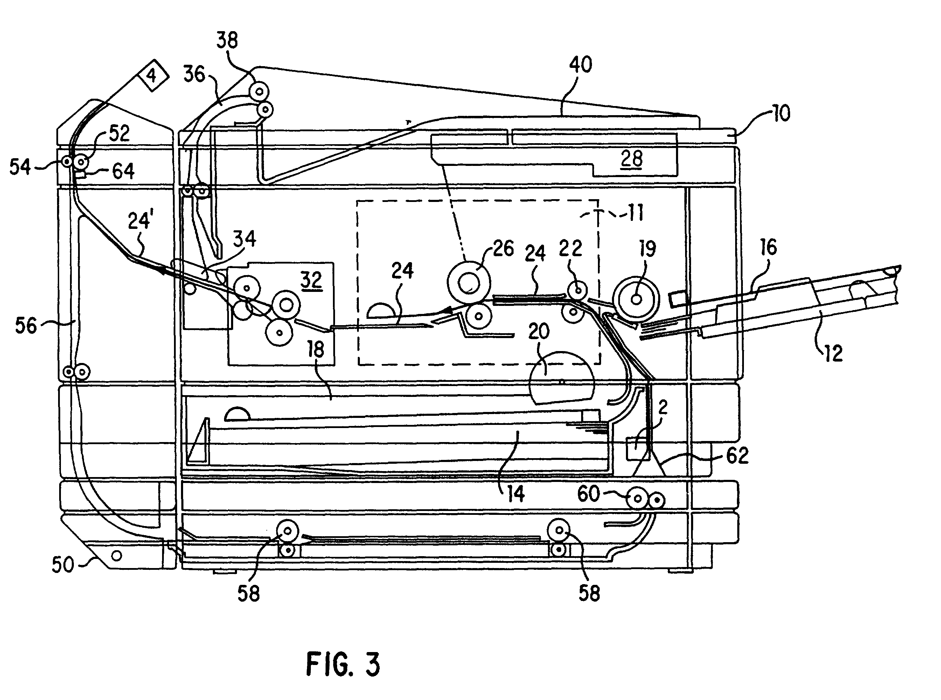

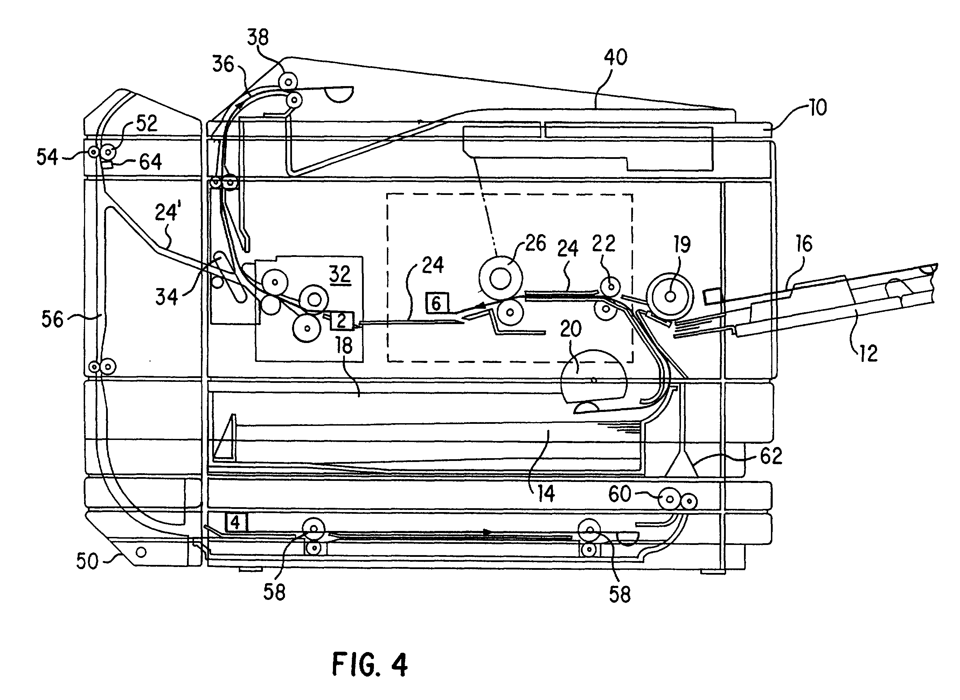

Fig. 3 shows that as the printed media cycled through the duplexer to print the second page, which is actually page 1, the bottom is first presented to PC drum 26. By following the paper path through Figs. 3 and 4, one would also see that printing now takes place from right to left. Thus, as stated earlier, in a duplex printer such as the one described and shown in Fig. 2, requires data for the second page printed be presented to the printer PC drum 26 in the reverse order.

Still in the art of printers, the present day trend is to reduce the memory requirements of such printers, thereby reducing the overall cost and improving performance. Modern printers incorporate various compression techniques to compress graphical image data thereby reducing memory requirements for such printers.

US-A-5 151 797 relates to an image forming apparatus for an image formation in accordance with first image data acquired by a forward movement of a scanner in an image reading unit of the image forming apparatus and further in accordance with second image data acquired by a return movement of the scanner. The first and second image data are stored into a storing means. To form the image, the first image data is read in a first reading order from the storing means and the second image data is read in a second reading order from the storing means wherein the second reading order is opposite to the first reading order.

US-A-4 568 983 relates to the compression and decompression of image data. According to this prior art compression/decompression method the bidirectional decoding of encoded data blocks is possible by utilization of fixed-length coded words, a forced definition of at least the first and the last data word of each strip of coded words as text and the utilization of synchronization code words. The synchronization words indicate characteristics of coded data to be decoded when decompressed in the forward direction, while in the reverse direction the synchronization words verify characteristics of the information just decoded.

Therefore it is the object of the present invention to provide a new method of compressing data in the normal direction and then decompressing the data in the reverse direction.

This object is achieved by a data compression and decompression method according to claim 1.

Brief Description of the Drawings

FIG. 1 is a side schematic diagram of a printer with a duplexing mechanism attached.

FIG. 2 is a timing diagram helpful in understanding the operation of the printer.

FIG. 3 is the printer shown in Fig. 1 at a further point in its operation.

FIG. 4 is the printer shown in Fig. 3 at a further point in its operation.

FIG. 5 shows a graphical window with a relatively simple line art object therein.

FIG. 6 gives an RLE encoding arrangement that could be used with the present invention.

FIG. 7 shows a similar graphical window as that shown in FIG. 5, however, the object therein is not compressible.

FIG. 8 one possible representation of the mark used in FIG 13.

FIG. 9 shows the state diagram used to compress data in accordance with the present invention.

FIG. 10 is a state diagram used when decompressing data in the reverse direction.

FIG. 11 is a state diagram used when decompressing data in the forward direction.

FIG. 12 represents the data when a fixed blocking size is used without markers.

FIG. 13 shows the markers being used in accordance with the present invention.

FIG: 14 is a high level functional diagram of a printer system that uses the present invention.

Detailed Description of the Invention

As stated above, data compression is the process of converting data from one format to a second where the second format requires less space. Previous data'compression schemes all assume that the data would be decompressed in the forward direction. While this is most often true, some special applications require decompression of the data in the reverse direction.

The present invention allows for decompression in either the forward or reverse directions. Such reversibility can be accomplished in one of two primary ways. First, a periodic marker can be placed in the compressed data stream. Each marker contains information necessary to decode a block of the compressed data and possibly the location of the next marker. Thus, by retrieving the markers in proper order and decompressing the blocks, the decompression can be guided in either the forward or reverse direction.

Another approach assumes that the compression method itself is periodic. Using this assumption, decompression can start at any periodic block of compressed data. By simply stepping through the periodic blocks in the reverse order, the data can be decompressed in the reverse direction. Each of these methods are described in greater detail below.

To aid the reader in understanding the present invention, a relatively simple compression technique will first be described and applied to a sample of data. Next, the modifications to this compression technique that will allow reverse direction decompression will be shown.

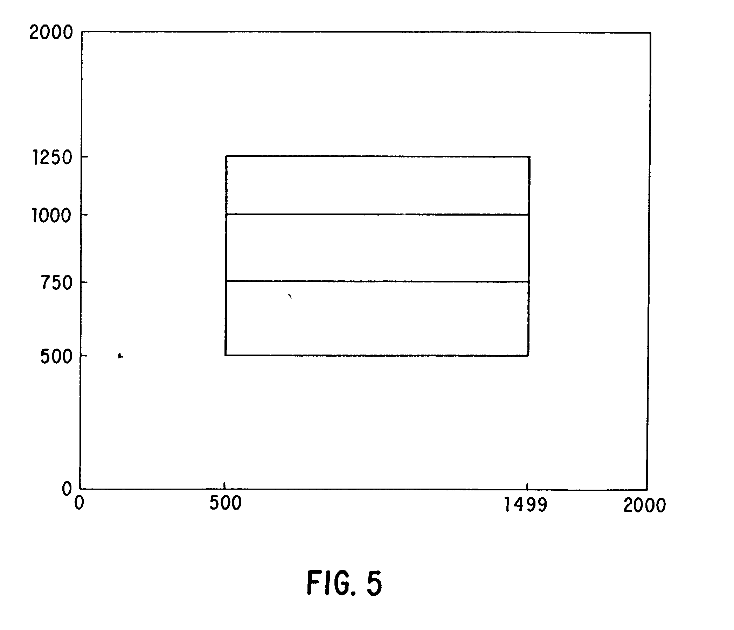

By way of an example, a region to be compressed is shown in figure 5. The area of figure 5 is described as a two-dimension X-Y coordinate system. Thus, from figure 5;

$$0 <= X <= 2000$$

and;

$$0 <= Y <= 2000.$$

Generally, a computer system uses a similar two-dimensional arrangement to describe its screen. Likewise, a printer system may also use such a arrangement. With either system, the object is displayed, or printed, as a series of dots known in the art as pixels. In the present example, each point (x, y) represent a unique pixel. Assuming that each pixel requires one byte, then the region of figure 5 requires 2001*2001 or 4,004,001 bytes memory.

Still referring to figure 5, the region contains a box having a lower left-hand corner at (500,500) and an upper right-hand corner at (1499, 1250). Inside the box are two straight lines. To store one line of the picture requires 2001 bytes. Looking now at table 1, the horizontal line at y = 1250 is described. The left-hand column represents the byte location, which is directly related to the x value. The right-hand column shows the value stored in the corresponding memory location. Thus to store the line requires 2001 bytes of memory. Table 1 clearly shows the redundancy of the data. As stated above, the data must contain redundancy for compression schemes to operate.

As discussed above, several data compression schemes are known in the art. Because in the present example graphical data is being compressed, RLE encoding has been chosen. Generally, RLE uses a count field and an identifier field. Several variations are possible, with each variation being designed for the anticipated type of data.

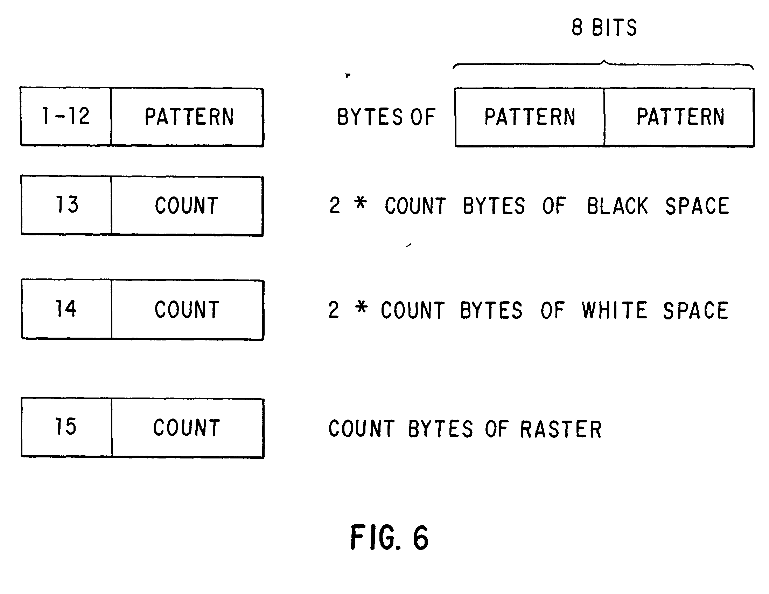

Referring next to figure 6, one possible version of an RLE scheme is shown. In figure 6 an RLE byte is divided into two nibbles each with four bits. The first four bits represent an RLE code, while the last four bits are a function of the RLE code. If the first nibble contains a value of 1 to 12, then the second nibble defines a pattern that is repeated 1 to 12 times.

Because objects tend to contain large areas of black or white, they are given a separate code. Thus, if the RLE code is 13, the second nibble defines the number of black words. In a similar manner, with an RLE code of 14 the second nibble defines the number of white words. Finally, an RLE code of 15 signals that there are COUNT bytes of un-compressed data following. This particular arrangement of RLE codes and definitions have been chosen to aid the reader in understanding the present invention. Such information is not meant to limit the present invention to this arrangement.

Referring back to figure 5, the following description explains how the above RLE scheme reduces the amount of memory required. Line y = 1250 of figure 5 can be described as having three regions. First the line is white from O to 499, followed by a black region from 500 to 1499, and the third region is white from 1500 to 2000. Table 2 shows memory content for the same line as table 1 however, in table 2 the above RLE compression scheme is used. In table 2, memory contents are shown on the right-hand side with the values shown in hexadecimal. Because the left-hand side no longer corresponds to the x value, it gives a count of duplicate values.

The white portion from 0 to 499 is encoded by noting that it contains 500 bytes of white. Referring to figure 6, we see that white is encoded using two bytes, herein referred to as words. Thus, the white section is comprised of 250 words of white. Using the definition of figure 6, white words are encoded with [14][COUNT]. Because the present definition of COUNT is limited to a 4-bit nibble, the maximum value that COUNT can hold is 15. Therefore the question is, how many 15 word chunks are necessary to describe 500 bytes. Dividing 250 by 15 yields 16.67. Thus, table 2 starts with 16 values of [14][15] or 'EF' in hex. However, these 16 bytes only describe a white line of 16*15*2 = 480 bytes. The remaining 20 bytes, or 10 words, of the white line are encoded in the single byte [14][10] or 'EA' hex. Thus, the first region, which required 500 bytes to store with no compression, now only requires 17 bytes to store.

In a similar manner, the black line from 500 to 1499 is encoded into 33 bytes of 'DF' ([13][15]) and one byte of 'D5' ([13][5]) thereby reducing the original 1000 bytes to 34 bytes. Finally, the white section from 1500 to 2000 is encoded into 16 bytes of 'EF' and one byte of 'EB'. Adding up the memory requirements shows that the compression ratio is:

$$2001/68 \cong 29.43 \text{ to } 1.$$

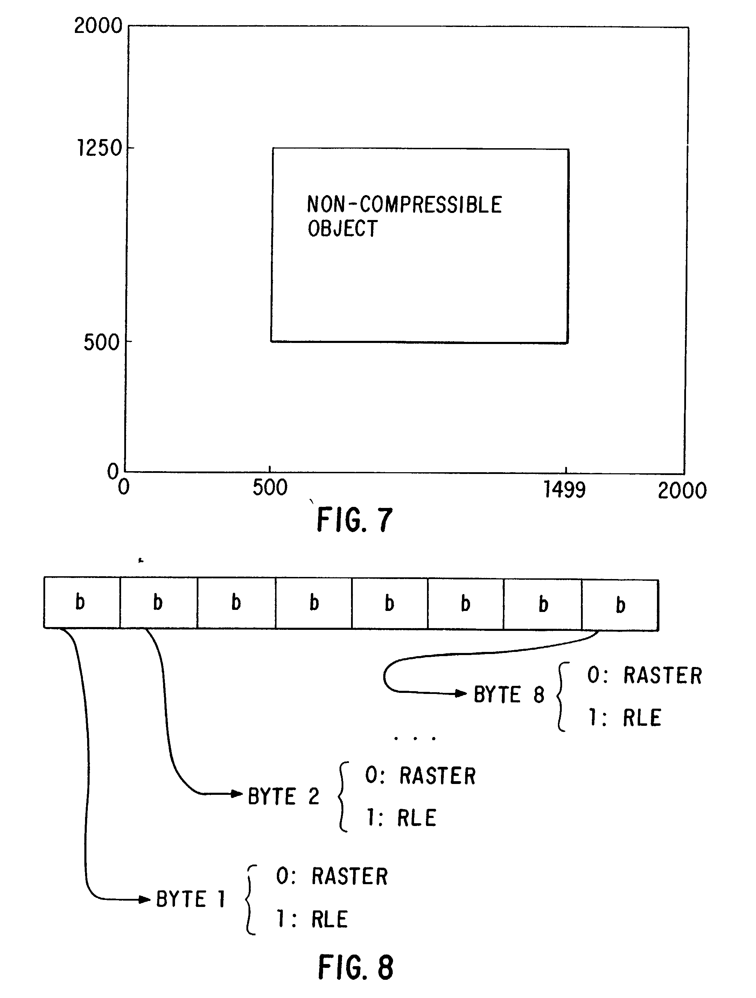

Referring next to figure 7, the simple box of figure 5 has been replaced with a non-compressible object. This arrangement is used to demonstrate how RLE compression handles non-compressible material. Referring also to table 3 where the results of compression of line y = 1249 are shown. As with the previous example, the line can be considered as containing three sections, white from 0 to 499, un-compressible from 500-1499, and white again from 1500 to 2000. The first white section compresses to 16 bytes of 'EF' and one byte of 'EA'. Compression of the second white line produces 16 bytes of 'EF' and one byte of 'EB'. Because the section from 500 to 1499 has been defined as non-compressible, no compression is performed. Data that is not compressed is said to be in raster format. However, this raster data must still conform to the compression scheme. As shown in figure 6, raster data can be stored in a maximum packet of 15 bytes with a compression code as a type of header of 'FF' ([15][15]). With this arrangement, the 1000 bytes of raster data is divided into 15 byte packets. The 1000 bytes are divided by 15 to get 66.67. Thus the table has 66 packets with a header value of 'FF' followed by 15 bytes of raster data and one packet with a header value of 'FA' followed by 10 bytes of raster data. As with most compression schemes, un-compressible portions require more space to store in a compressed format then does the original data. Specifically, the portion from 500 to 1499 originally required 1000 bytes to store. Using the present example compression scheme, that same portion now requires 1067 bytes to store. However, compression of the entire line does reduce memory requirements by:

$$2001/1101 \cong 1.82 \text{ to } 1.$$

Decompression is accomplished by reading a byte from memory, interpreting the code and executing the proper instruction. Thus, in the case of table 3, the first byte 'EF' is read and interpreted as meaning write 15 words of white. In a similar manner, the byte 'FF' means the next 15 bytes are uncompressed data. It is this uncompressed code that makes reverse decompression of RLE impossible. For example, when attempting to decompress in the reverse direction, the first byte read is 'EB'. But it is impossible, without additional information to determine if 'EB' is a valid RLE code or if it is raster data.

With that brief description of the problem, a means and method to allow the above scheme to decompress the data in the reverse direction will now be described. Continuing on with the RLE compression as shown in table 2, in one embodiment, the compressed code is divided into known block sizes and a marker is placed at the beginning of the block. This mark describes the type of data in the forthcoming block or in the alternative, the marker could describe the type of data in the previous block. One possible arrangement of such a marker is shown in figure 8.

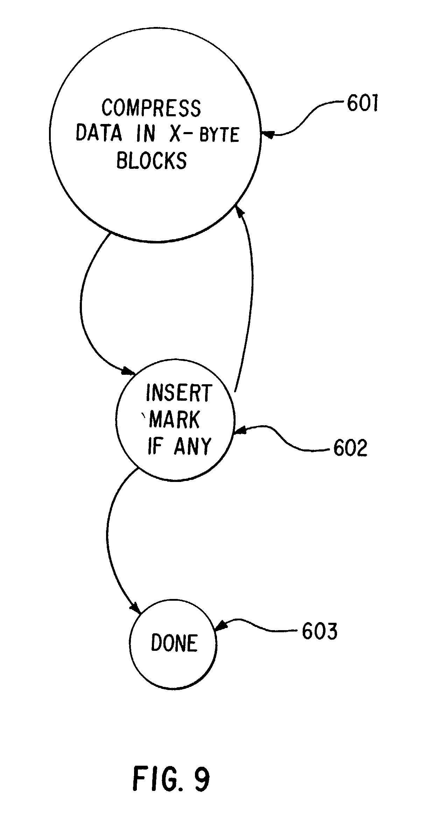

Using a block size of eight, the marker shown in figure 8 encodes the status of each of the eight bytes in a single bit of the marker. Thus if the first byte of the block of data is a valid RLE byte, then the first bit of the marker is set to a one. Compression of data including the markers is relatively simple as shown in figure 9. The data is compressed into X-byte blocks 601. In the present example, X has been chosen as eight. After eight bytes have been compressed, the marker is created and stored in the data stream 602. If the embodiment uses pre-markers, that is the marker describes the forthcoming block, then the marker is placed into the data stream before the compressed data. If, in the alternative, the embodiment uses post-markers, then the marker is placed into the data stream after the compressed data.

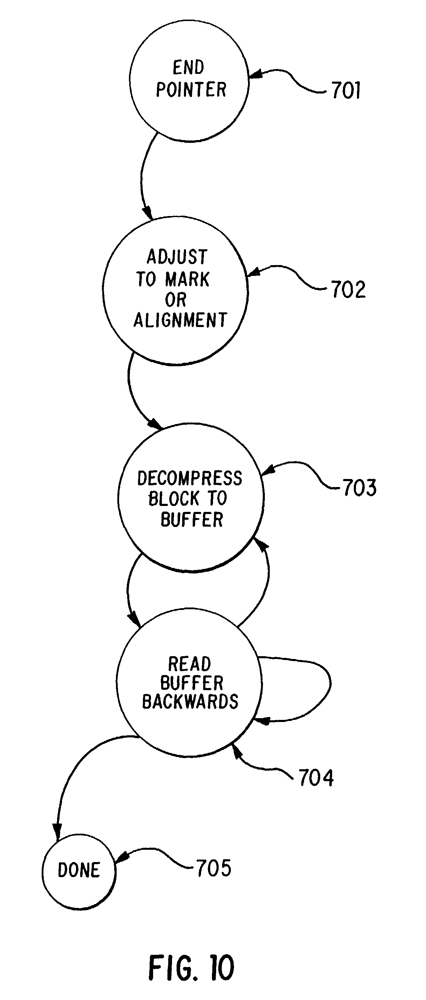

Decompressing this arrangement is shown in figure 10. First, the end pointer is retrieved 701. Next, the pointer is adjusted to find the last marker 702. If the embodiment uses pre-markers, the pointer is adjusted to point to the last marker. If the embodiment uses post-markers, the last byte should be a marker describing the previous block of data. The block of data is decompressed in the forward direction into a buffer 703. Once the block has been decompressed, the buffer is read backwards 704 thereby generating the data in the reverse direction. It should be noted that taking into consideration that by definition, a single RLE code decodes into a number of identical bytes, therefore, the use of a buffer becomes optional. Without the buffer, each RLE code is decoded directly into the output stream.

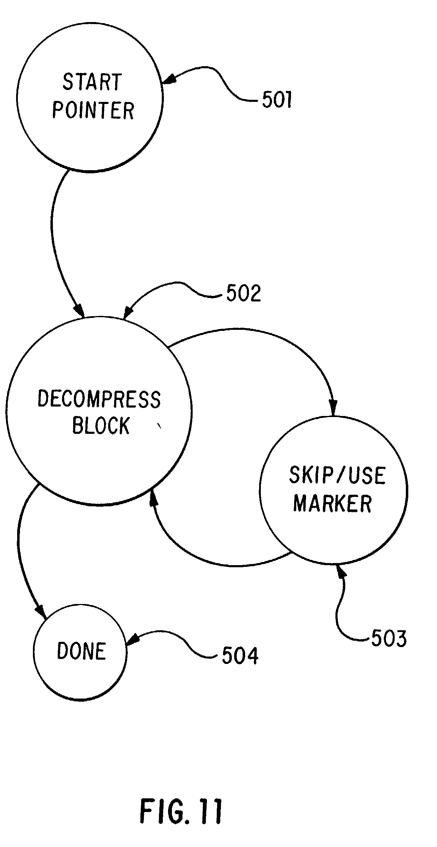

The decompression process in the forward direction is shown in figure 11. Here, the marker would generally be skipped over 502. However, it is conceivable to use the pre-marker to describe the data to the decompressor.

Using a pre-marker arrangement, the same data as compressed in Table 3 is shown in Table 4. Here, the marker of Fig. 8 is used. As described earlier, using the marker arrangement of Fig. 8 requires that the compressed data be broken into eight byte blocks. Referring to Table 4, the first byte is a marker 'FF'. Because the next eight bytes are all RLE codes, the marker has all eight bits set to one. This is also true for the second marker.

When the data becomes un-compressible, the compression routine must break the compressed data into eight byte blocks plus a marker at the start of each block. As a result of this requirement, the un-compressible data can only be stored in eight byte blocks or less. With renewed reference to Table 4, the third marker has a value of '80' Hex or 1000 0000 binary. Interpreting this marker shows that the first byte ('EA') is a valid RLE code and that the last seven bytes are raster. In a similar manner, the fourth marker '00' signifies that all eight bytes are raster. By simple arithmetic it can be shown that 124 blocks of eight bytes and one byte are necessary to describe the un-compressible region. The next marker '7F' signifies that the one remaining raster byte follows, with seven bytes of RLE codes. Finally, because the compressed data may not be evenly divisible by eight, an optional ending marker pointing to the last valid marker is shown. Omission of the ending marker necessitates the determination of the last marker's position by dividing the compressed file size by nine and adjusting for any remainder.

Adding the additional space to store the markers plus the reduced block size to describe the un-compressible region, yields a compression ratio of:

$$2001/1165 \cong 1.727 \text{ to } 1.$$

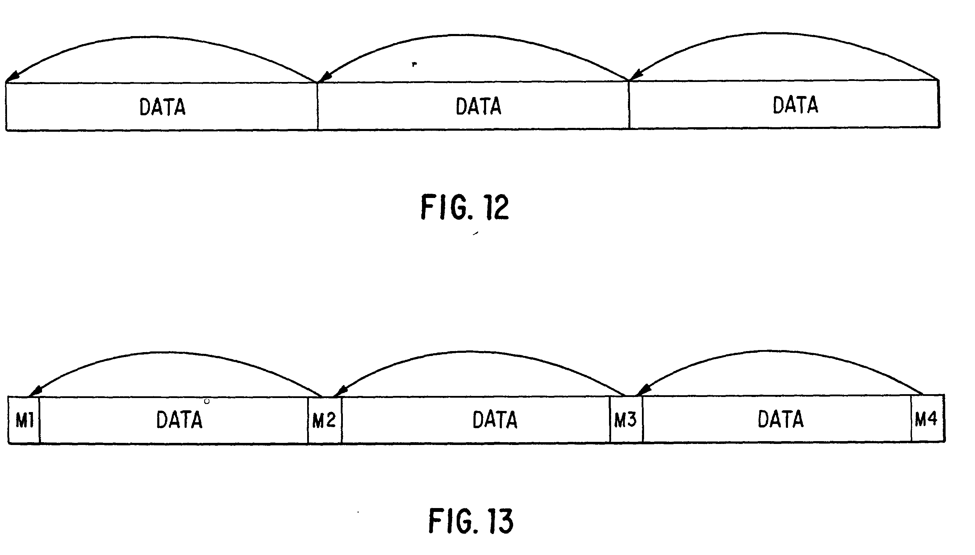

A second embodiment uses a similar method, except that the markers are excluded. With this embodiment, as shown in figure 12, the block sized is fixed. The primary modification necessary to decode this embodiment is that the encoder must insure that the beginning byte of each block is a valid RLE byte and not a raster data byte. Such an arrangement may require raster data be broken into more packets then would nominally be necessary to encode.

Decompressing this arrangement is similar to that shown in figure 10. First, the end pointer is retrieved 701. Next, the pointer is adjusted to align with the start of the last block 702. The block of data is decompressed in the forward direction into a buffer 703. Once the block has been decompressed, the buffer is read backwards 704 thereby generating the data in the reverse direction.

Because no marker has been inserted, decompression in the forward direction is exactly the same as when a non-reversible RLE scheme is used.

Use of the arrangement of figure 12 is shown in Table 5. This table uses a blocking size of 16 because such a size matches the maximum block size for un-compressible data. Looking at the table shows that only two lines are different from that of Table 3, namely, the first line of un-compressible data has been decreased by one and the last line of un-compressible data has been increased by one. Again, either an ending marker can be used or the last block can be calculated as described above. Thus, in this example, if the ending marker is omitted, the file size for a reversible compression arrangement is the same as the non-reversible. Depending on the input data the reversible compressed file may not be the same size as the non-reversible. This particular arrangement of RLE codes, block size, and markers have been chosen to aid the reader in understanding the present invention. Such information is not meant to limit the present invention to using this arrangement.

Yet another embodiment uses the marker as a backwards pointer as shown in figure 13. Such a pointer could point backwards to the beginning of a block or the start of a line, or any other point in the data. As with the embodiment of figure 12, the encoder must insure that the pointer points back to a valid RLE byte and not a raster data byte. The primary advantage of this embodiment is the increased and variable block size, which produces a comparable reduction in the number of markers used, thus improving the compression ratio. Decompression in the forward direction is shown in figure 11. Here, the marker would generally be skipped over 502.

Other compression schemes are known in the art. For example, one of the most popular general purpose schemes is known as the LZ78 family of compressors. LZ78-based schemes work by entering phrases into a "dictionary" and then, when a repeat occurrence of that particular phrase is found, outputting the dictionary index instead of the phrase. There exist several compression algorithms based on this principle, differing mainly in the manner in which they manage the dictionary. The primary advantage to this type of compression is that the entire dictionary has been transmitted to the decoder without actually explicitly transmitting the dictionary. At the end of the run, the decoder will have a dictionary identical to the one the encoder has, built up entirely as part of the decoding process.

The LZ78 compression scheme can also be modified to allow reverse decompression. One embodiment uses markers embedded in the compressed data as described earlier. A marker is placed in the data whenever a change is made to the dictionary. Furthermore, the marker provides an offset to the next marker. By using the markers, the decompressor can reconstruct the dictionary in the forward direction. Once the decompressor reaches the desired point, decompression begins. The block is decompressed into a buffer and the buffer is read backwards thereby outputting the data in the reverse direction. Decompression in the forward direction must ignore the markers. Because markers require additional space to store, this embodiment adversely affects the compression ratio.

Another embodiment does not require the use of markers. By eliminating the markers, the compression ratio is not adversely affected. However, the dictionary must be reconstructed in the forward direction. Reconstruction of the dictionary requires that the data be read forward only for the purpose of constructing the dictionary. Once the decompressor reaches the desired point, decompression begins. The block is decompressed into a buffer and the buffer is read backwards. Decompression in the forward direction is unaffected. This embodiment does not adversely affect the compression ratio, however, additional processing time is necessary to reconstruct the dictionary thereby adversely affecting the performance.

Other possibilities might include storing the dictionary with the data stream. By storing the dictionary in the data stream, no additional time is necessary to rebuild the dictionary. This approach has two primary disadvantages. First, the compression ratio is adversely affected by the need to store the dictionary. Second, this requires the dictionary be a static dictionary. Stated differently, once the dictionary is full no more changes can be made. This also adversely affects the compression ratio.

Another approach fixes the output block size from the compressor and requires the dictionary to be reset at the start of each block, the decompressor can then start decompressing at the start of any block. Here again, the compression ratio is adversely affected because this compression scheme results in poor compression during the initial portion of each block because of the frequent entries in the dictionary.

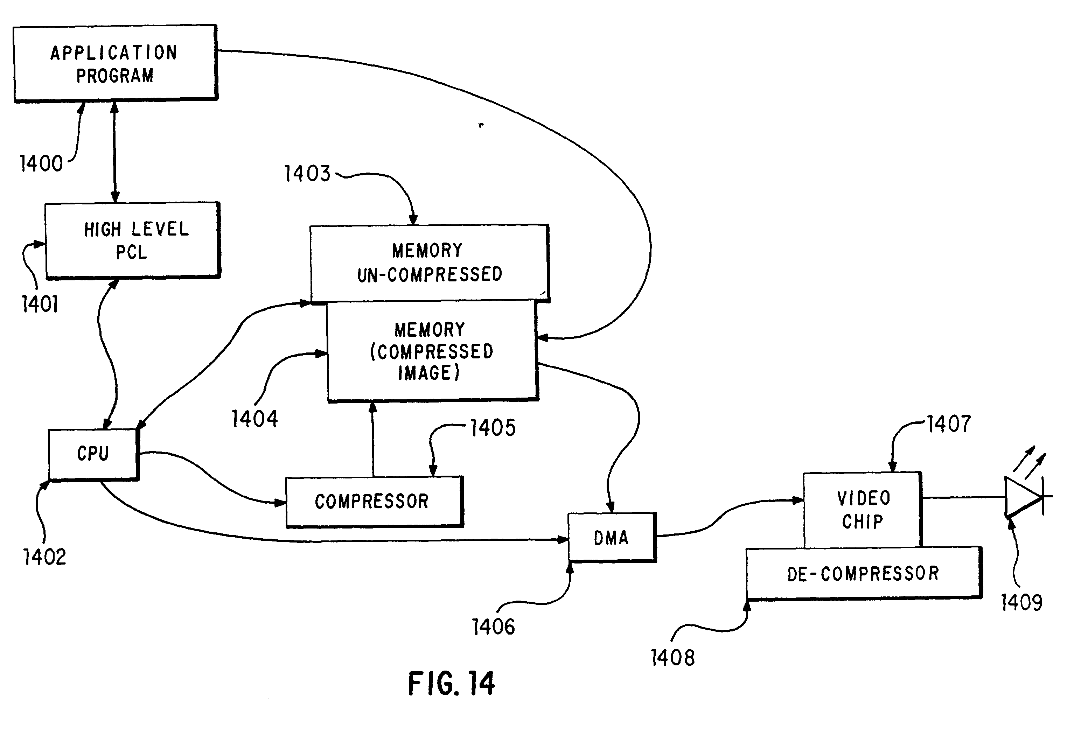

As was stated earlier one particular application that makes use of the reversible data compression method is a duplex printer. Referring to Fig. 14, a generic block diagram of one such printer is shown. Note that APPLICATION PROGRAM 1400 shown in Fig. 14 is not part of the printer system.

While the reversible data compression method can be used several ways with the block diagram of Fig. 14, two primary ways will be discussed here. Selection of a particular method is primarily determined by projected cost of the overall printer system. With a more expensive implementation, CPU 1402 has sufficient processing power and memory to accomplish the compression algorithm itself. With a low cost printer system, CPU 1402 may not be present and memory requirements are kept to a minimum. With the inexpensive arrangement the application program 1400 must implement the compression algorithm.

With the high performance printer system, application program 1400 sends data to the printer system using a high level printer control language 1401. CPU 1402 retrieves the data from the high level printer control language 1401 and rasterizes that data in an uncompressed format into memory 1403. Next, the CPU retrieves the uncompressed rasterized information from 1403, passes it through compressor 1405, which then stores the compressed image back into memory 1404. At the appropriate time DMA 1406 under control of CPU 1402 retrieves the compressed image from memory 1404. The compressed image is then transferred to decompressor 1408, which performs the decompression algorithm. The output of decompressor 1408 is fed to video chip 1407 which modulates laser 1409 in accordance with the uncompressed image information.

Using this arrangement, application program 1400 is completely removed from the decision as to when a compressed image stored in 1404 must be read in the reverse direction by DMA 1406 and decompressed in the reverse direction by decompressor 1408. By insulating the application program 1400 such programs are not unnecessarily complicated.

The second arrangement is an effort to minimize the cost of the printer system itself. Such an arrangement uses only memory 1404, DMA 1406, decompressor 1408, video chip 1407 and laser diode 1409. Because the printer system does not contain a CPU, application program 1400 must implement the entire compression algorithm. However, the application program does not need to have foreknowledge of whether the compressed image is to be printed in the forward or reverse direction. Both DMA 1406 and decompressor 1408 must know whether the image is to be decompressed in the reverse direction. DMA 1406 needs to know this so that it can retrieve the compressed image in the reverse direction from memory location 1404. Decompressor 1408 must know the direction as well so that it can properly apply the correct algorithm.

Additional throughput between application program 1400 and the printer system can be accomplished by allowing the application program 1400 to rasterize data and then compress it prior to sending it to the printer system. Using the reversible data compression method the application program can compress the rasterized information and then embed it in the proper page description language prior to transmitting it to the high level PCL block 1401. When CPU 1402 retrieves the page description language instruction it will decode the instruction to mean that the following information is compressed, rasterized data. Thus, CPU 1402 bypasses this step of compression and directly places the compressed data into compressed image memory 1404. As before DMA 1406 again retrieves the compressed image from 1404 transmitting it to decompressor 1408 which decompresses it and passes it onto video chip 1407 and laser diode 1409. With this arrangement application program 1400 must still compress the rasterized information prior to sending it to the printer system. However, application program 1400 is not required to manage the memory of the printer system as it would be with the second approach.

In the normal printing process, DMA 1406 retrieves the compressed image from memory 1404 and, as before, feeds it to decompressor 1408 which decompresses the compressed image. This arrangement may significantly reduce the cost of the printer system since CPU 1402 is no longer necessary. However, such an arrangement does place an additional burden on application program 1400 to rasterize and compress the image.

Table 1

| (y=1250)For Figure 5 No compression | |
|---|---|
| Byte | Value (HEX) |
| 0 | 0 |
| 1 | 0 |
| 2 | 0 |
| ... | 0 |
| 499 | 0 |
| 500 | 1 |
| 501 | 1 |
| ... | 1 |
| 1499 | 1 |
| 1500 | 0 |
| 1501 | 0 |
| ... | 0 |
| 2000 | 0 |

Table 2

| (y=1250)For Figure 5 RLE Compression | |
|---|---|
| Number | Value (HEX) |
| 1 | EF |
| 2 | EF |
| ... | EF |
| 16 | EF |
| 1 | EA |
| 1 | DF |
| 2 | DF |
| ... | DF |
| 33 | DF |
| 1 | D5 |
| 1 | EF |
| 2 | EF |
| ... | EF |
| 16 | EF |
| 1 | EB |

Table 3

| (y=1249)For Figure 7 RLE Compression | |
|---|---|
| Number | Value (HEX) |
| 1 | EF |
| 2 | EF |
| ... | EF |
| 16 | EF |
| 1 | EA |
| 1 | FF, [15 BYTES OF RASTER] |
| 2 | FF, [15 BYTES OF RASTER] |
| ... | FF, [15 BYTES OF RASTER] |
| 66 | FF, [15 BYTES OF RASTER] |
| 1 | FA, [10 BYTES OF RASTER] |
| 1 | EF |
| 2 | EF |
| ... | EF |
| 16 | EF |
| 1 | EB |

Table 5

| (y=1249)For Figure 7 Reversible RLE Compression | |
|---|---|
| Number | Value (HEX) |
| 1 | EF |
| 2 | EF |
| ... | EF |
| 16 | EF |
| 1 | EA |
| 1 | FE, [14 BYTES OF RASTER] |
| 2 | FF, [15 BYTES OF RASTER] |
| ... | FF, [15 BYTES OF RASTER] |
| 66 | FF, [15 BYTES OF RASTER] |
| 1 | FB, [11 BYTES OF RASTER] |
| 1 | EF |
| 2 | EF |
| ... | EF |
| 16 | EF |
| 1 | EB |

Table 4

| (y=1249)For Figure 7 Reversible RLE Compression | |
|---|---|
| Number | Value (HEX) |
| 1 (MARKER) | FF |
| 1 | EF |
| 2 | EF |
| ... | EF |
| 7 | EF |
| 8 | EF |
| 1 (MARKER) | FF |
| 1 | EF |
| 2 | EF |
| ... | EF |
| 7 | EF |
| 8 | EF |
| 1 (MARKER) | 80 |
| 1 | EA |
| 1 | [7 BYTES OF RASTER] |
| 1 (MARKER) | 00 |
| 1 | [8 BYTES OF RASTER] |

# EP 0 660 587 B1

Table 4   (continued)

| (y=1249)For Figure 7 Reversible RLE Compression | |
|---|---|
| Number | Value (HEX) |
| 1 (MARKER) | 00 |
| 1 | [8 BYTES OF RASTER] |
| 1 (MARKER) | 00 |
|  |  |
| 1 (MARKER) | 7F |
| 1 | [1 BYTE OF RASTER] |
| 1 | EF |
| 2 | EF |
| ... | EF |
| 8 | EF |
| 1 (MARKER) | FF |
| 1 | EF |
| 2 | EF |
| ... | EF |
| 7 | EF |
| 8 | EF |
| 1 (MARKER)<br>1 | 80<br>EF |
| 1 | EB |
| 1 (MARKER) | 02 |

## Claims

1. A data compression and decompression method for compressing an original data into a compressed data and decompressing said compressed data into a reverse data wherein said reverse data is said original data in reverse order, said method comprising the step of:

   compressing (601) said original data into compressed data comprising a plurality of blocks of a fixed size including a first block and a last block,

   characterized in that

   each block begins with encoding data; and

   said method further comprises the steps of:

   beginning with said last block,

   retrieving (701, 702) said block from said plurality of blocks;

   decompressing (703) said block and storing corresponding decompresssed data in a forward direction into a buffer means;

   reading (704) said buffer means in a reverse direction relatively to said forward direction; and

11

repeating said steps of retrieving (701, 702), decompressing (703) and reading (704) for all blocks of said plurality of blocks in the order from the last block to the first block.

**Patentansprüche**

1. Ein Daten-Komprimierungs- und Dekomprimierungsverfahren zum Komprimieren von ursprünglichen Daten in komprimierte Daten und Dekomprimieren der komprimierten Daten in umgekehrte Daten, wobei die umgekehrten Daten die ursprünglichen Daten in umgekehrter Reihenfolge sind, wobei das Verfahren folgende Schritte aufweist:

Komprimieren (601) der ursprünglichen Daten in komprimierte Daten, die eine Mehrzahl von Blöcken einer festen Größe mit einem ersten Block und einem letzten Block aufweisen,

dadurch gekennzeichnet, daß

jeder Block mit Codierdaten beginnt; und

das Verfahren ferner folgende Schritte aufweist:

Beginnen mit dem letzten Block,

Wiedergewinnen (701, 702) des Blocks aus der Mehrzahl von Blöcken;

Dekomprimieren (703) des Blocks und Speichern der entsprechenden dekomprimierten Daten in einer Vorwärtsrichtung in einer Puffereinrichtung;

Lesen (704) der Puffereinrichtung in einer umgekehrten Richtung relativ zu der Vorwärtsrichtung; und

Wiederholen der Schritte des Wiedergewinnens (701, 702), des Dekomprimierens (703) und des Lesens (704) für alle Blöcke der Mehrzahl von Blöcken in der Reihenfolge von dem letzten Block zu dem ersten Block.

**Revendications**

1. Procédé de compression et de décompression de données pour comprimer des données originales en des données comprimées et décomprimer lesdites données comprimées en des données inverses, selon lequel lesdites données inverses sont lesdites données originales dans l'ordre inverse, ledit procédé comprenant l'étape consistant à :

comprimer (601) lesdites données originales en des données comprimées, comprenant une pluralité de blocs ayant une taille fixe et incluant un premier bloc et un dernier bloc,

caractérisé en ce que

chaque bloc commence par des données de codage ; et

ledit procédé comprend en outre les étapes consistant à :

commencer par ledit dernier bloc,
récupérer (701,702) ledit bloc à partir de ladite pluralité de blocs;
décomprimer (703) ledit bloc et mémoriser des données décomprimées correspondantes dans une direction d'avance dans des moyens formant tampon;
lire (704) lesdits moyens formant tampons dans une direction inverse par rapport à ladite direction d'avance; et
répéter lesdites étapes de récupération (701,702), de décompression (703) et de lecture (704) pour tous les blocs de ladite pluralité de blocs dans l'ordre allant du dernier bloc au premier bloc.

FIG. 1

EP 0 660 587 B1

EP 0 660 587 B1

| PAGE REC'D INTO MEMORY | 2 | 3 | 4 | 5 | 6 | 7 | 8 |
|---|---|---|---|---|---|---|---|

AT PC DRUM    2    4    1    6    3    8    5    7

DUPLEX REVERSING ROLLER    2    4    6    8

IN DUPLEXER    80    2    4    6    8

AT OUTPUT ROLLER    1/2    3/4    5/6    7/8

OUT-RELEASE FROM MEMORY    1/2    3/4    5/6    7/8

FIG. 2

FIG. 3

EP 0 660 587 B1

FIG. 4

FIG. 5

EP 0 660 587 B1

8 BITS

| 1-12 | PATTERN |
|------|---------|

BYTES OF

| PATTERN | PATTERN |
|---------|---------|

| 13 | COUNT |
|----|-------|

2 * COUNT BYTES OF BLACK SPACE

| 14 | COUNT |
|----|-------|

2 * COUNT BYTES OF WHITE SPACE

| 15 | COUNT |
|----|-------|

COUNT BYTES OF RASTER

# FIG. 6

FIG. 7

FIG. 8

FIG. 9

FIG. 10

FIG. 11

FIG. 12

FIG. 13

23

FIG. 14

EP 0 660 587 B1